# EUROPEAN PATENT SPECIFICATION

(11) **EP 0 668 655 B1**
(45) Date of publication and mention of the grant of the patent: **03.05.2000**
(21) Application number: 95102296.1
(22) Date of filing: 17.02.1995
(51) Int. Cl.: H03H 9/64

(54) **Balanced-type surface acoustic wave filter**
Symmetrisches akustisches Oberflächenwellenfilter
Filtre à ondes acoustiques de surface du type équilibré

(30) Priority: 22.02.1994 JP 2402794
(43) Date of publication of application: 23.08.1995
(73) Proprietor: Matsushita Electric Industrial Co., Ltd., Kadoma-shi, Osaka 571 (JP)
(72) Inventor: Taguchi, Yutaka, Matsushita Elec. Ind. Co., Ltd., Ibaraki-shi, Osaka 567 (JP); Eda, Kazuo, Matsushita Elec. Ind. Co., Ltd., Nara-shi, Nara 631 (JP); Seki, Shunichi, Matsushita Elec. Ind. Co., Ltd., Osaka-shi, Osaka 532 (JP); Onishi, Keiji, Matsushita Elec. Ind. Co., Ltd., Settsu-shi, Osaka 566 (JP)
(74) Representative: VOSSIUS & PARTNER

(56) References cited:
- US-A- 4 785 270
- 1974 Ultrasonics Symposium Proceedings; New York , US: S.C.Tseng et al: SAW Planar Network; p282-285

## Description

This invention relates to a balanced-type surface acoustic wave filter used for communication equipment.

Recently, a surface acoustic wave element used for filters has been intensively developed. In particular, along with the recent advancements in mobile communications and the tendency towards higher frequency, the development of a surface acoustic wave element, and in particular a surface acoustic wave filter is now of great interest. Conventionally, several methods have been proposed to form filters used for high frequency bands, especially for several 100 MHz, with the use of surface acoustic wave element. As typical example of this filter, one type comprises a plurality of surface acoustic wave resonators as disclosed in JP-A-52-19044 and JP-A-5-183380. A so-called multielectrode type filter is disclosed in JP-A-58-154917. Another type, which is disclosed in JP-A-3-222512, is characterized by the steps of positioning surface acoustic wave resonators adjacent to each other and connecting these resonators.

Conventional surface acoustic wave filters were mostly so-called unbalanced-type filters. Basically, the multielectrode type filter can be used both in balanced and unbalanced forms. However, a filter with four terminals usually has one pair of input and output terminals which are connected directly and are used normally as earth terminals, so that the filter was only capable of processing unbalanced signals. On the other hand, high frequency circuits such as an amplifier or a mixer can improve their circuit characteristics when they use balanced signals. However, since a filter which was connected to these circuits, and which was indispensable for high frequency circuits, was not adjusted to balanced circuits, high frequency circuits used for balanced circuits needed to connect a balanced-unbalanced conversion circuit at a part where the filter was connected. This resulted in an increased number of components and higher costs, so that this type of filter was actually used only rarely.

As an example of a conventional balanced-type filter, a surface acoustic wave device is disclosed in JP-U-58-29627. This device uses the above-noted multielectrode type filter as a balanced-type filter and is disposed with a balanced-unbalanced conversion device for input and output. Therefore, as already mentioned above, the number of components is increased, so this filter is not generally used. Another example of a balanced-type filter is disclosed in JP-A-1-208010, in which surface acoustic wave resonators are connected to a lattice type circuit. In this case, however, the resonator is formed as a two-port resonator, and furthermore, this filter has no means to control resonance frequency and antiresonance frequency.

1974 Ultrasonics Symposium Proceedings; New York, US; S.C. Tseng et al: "SAW planar Network", pages 282-285, discloses an SAW filter according to the preamble of claim 1.

An object of this invention is to solve the above-mentioned problems in the conventional techniques by providing a balanced-type surface acoustic wave filter which can attain a balanced-type high frequency circuit without connecting a balance-unbalanced conversion circuit. This object is achieved with the features of the claims.

Furthermore, it is preferable that the inductance at connection parts where each surface acoustic wave resonator in the latticed arms is connected and the impedance at connection parts to be connected with serial arms, differ from each other.

Additionally, it is preferable that the equivalent parallel capacity of a surface acoustic wave resonator having lower resonance frequency is greater than the equivalent parallel capacity of a surface acoustic wave resonator having higher resonance frequency.

According to the above-noted embodiment of this invention, a balanced-type surface acoustic wave filter comprises four surface acoustic wave resonators connected symmetrically and latticed to form a symmetrical and latticed circuit, wherein one or more symmetrical and latticed circuits are used and arranged so that at least one of (i) antiresonance frequency in the latticed arms and resonance frequency in the serial arms, and (ii) resonance frequency in the latticed arms and antiresonance frequency in the serial arms, are substantially equal to each other. As a result, a balanced-type surface acoustic wave filter having excellent characteristics can be attained. In addition, since a balanced-type high frequency circuit can be attained without using a balance-unbalanced conversion circuit, the number of components and costs can be reduced.

Furthermore, according to the embodiment, it is preferable that the connection parts where each surface acoustic wave resonator is connected have approximately the same amount of inductance as a means to adjust resonance frequencies in the latticed arms and in the serial arms. Thus, a balanced-type surface acoustic wave filter having excellent characteristics can be attained regardless of how the surface acoustic wave resonator is designed.

In addition, it is preferable that the inductance at connection parts where each surface acoustic wave resonator in latticed arms is connected and the impedance at connection parts to be connected with serial arms, differ from each other. Accordingly, even if the ratio of equivalent capacity between the surface acoustic wave resonator in a serial arm and the surface acoustic wave resonator in a parallel arm is changed from 1 to 1, at least one of (i) antiresonance frequency in latticed arms and resonance frequency in serial arms, and (ii) resonance frequency in latticed arms and antiresonance frequency in serial arms, correspond approximately to each other in substance, thereby attaining a balanced-type surface acoustic wave filter having excellent characteristics.

It is preferable that the equivalent parallel capacity of a surface acoustic wave resonator having a lower resonance frequency is greater than the equivalent parallel capacity of a surface acoustic wave resonator having a higher resonance frequency, since attenuation poles can be created in the vicinity of pass frequencies of the filter. This is considered advantageous particularly when high attenuation is required.

When the symmetrical and latticed circuit is connected in a two-stage arrangement, there are no longer parts where wirings cross each other on a substrate surface, so that wire bonding can be facilitated. In this case, it is possible to obtain sufficient out-of-band rejection in comparison with the circuit of a one-stage arrangement.

Furthermore, when the symmetrical and latticed circuit is connected in a three-stage arrangement, there is no longer parts where wirings cross each other on a substrate surface, as with the above-mentioned connection in a two-stage arrangement, so that wire bonding can be facilitated. Also in this case, it is possible to obtain sufficient out-of-band rejection in comparison with the circuit of a one-stage arrangement. In addition, the half-value width becomes smaller than that of a two-stage connection.
FIG. 1 is a schematic view of a balanced-type surface acoustic wave filter in a first embodiment of this invention.
FIG. 2 is a view of an equivalent circuit in the balanced-type surface acoustic wave filter shown in FIG. 1.
FIG. 3 is a view showing an equivalent circuit of the resonators used for the balanced-type surface acoustic wave filter shown in FIG.1.
FIG. 4 is a graph showing frequency characteristics of the resonators used for the balanced-type surface acoustic wave filter shown in FIG. 1.
FIG. 5 is a schematic view showing a circuit for measuring filter characteristics.
FIG. 6 is a graph showing frequency characteristics of the balanced-type surface acoustic wave filter shown in FIG. 1.
FIG. 7 is a schematic view of a balanced-type surface acoustic wave filter in a second embodiment of this invention.
FIG. 8 is a graph showing frequency characteristics of the balanced-type surface acoustic wave filter shown in FIG. 7.
FIG. 9 is a graph showing frequency characteristics of a balanced-type surface acoustic wave filter in a fourth embodiment of this invention.
FIG. 10 is a schematic view of a balanced-type surface acoustic wave filter in a sixth embodiment of this invention.
FIG. 11 is a graph showing frequency characteristics of the balanced-type surface acoustic wave filter shown in FIG. 10.
FIG. 12 is a graph showing frequency characteristics of a balanced-type surface acoustic wave filter in a seventh embodiment of this invention.

This invention will be explained in detail with reference to the attached figures and the following examples. The examples are illustrative and should not be construed as limiting the invention in any way.

### Example 1

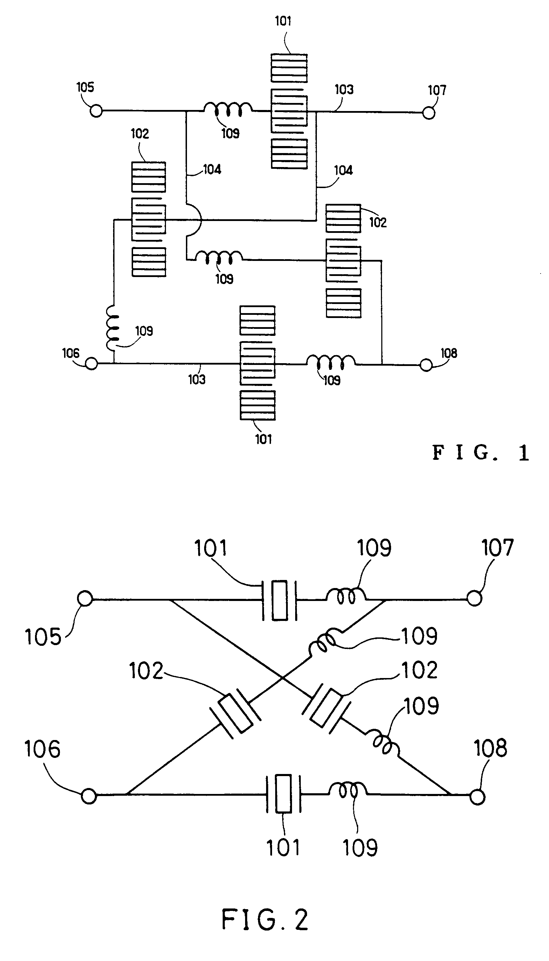

First, a first embodiment of this invention will be explained. FIG. 1 is a schematic view of a balanced-type surface acoustic wave filter in a first embodiment of this invention, and FIG. 2 is a view of an equivalent circuit of the balanced-type surface acoustic wave filter shown in FIG. 1. A circuit connected in a way shown in FIG. 2 is generally called a symmetrical and latticed circuit.

A substrate of tantalic acid lithium (LiTaO₃) with 36 degrees rotation, Y cut, and X propagation was used, and aluminium was used for the electrodes to form resonators 101 and 102. Then, as shown in FIGS. 1 and 2, two resonators 101 in the serial arm and two resonators 102 in the parallel arm are connected in the form of symmetry and lattice to form a balanced-type surface acoustic wave filter. In FIG. 1, reference numerals 103 and 104 represent connection parts connecting each resonator, and connecting electrodes formed on the substrate surface are used for the connection parts. In FIGS. 1 and 2, 109 represents an inductor which is connected serially to all the resonators. 105 and 106 represent input terminals, and 107 and 108 represent output terminals. Since connection wires cross on the substrate surface in this embodiment, the input terminal 105 was connected when wire bonding was conducted. Semiconductor techniques can be used for crossing on the substrate surface. Here, a number of electrode pairs and a number of reflector pairs are determined by the characteristics of a piezoelectric substrate. In this embodiment, the number of both electrode pairs and reflector pairs are actually about 100, but to simplify the description, the number of electrode pairs and reflector pairs are reduced in this figure.

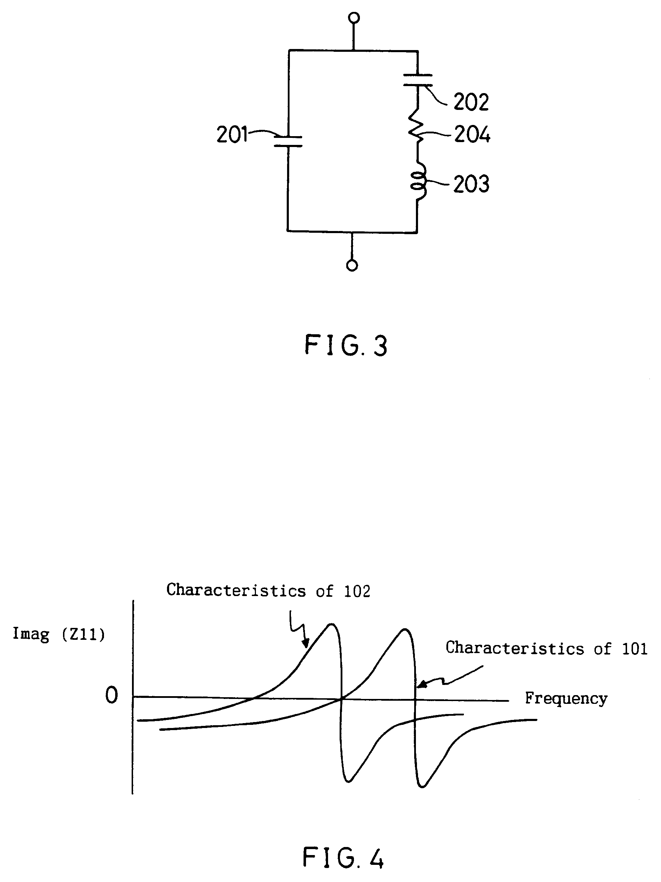

In the above-noted balanced-type surface acoustic wave filter, important factors that determine filter characteristics are resonance frequency and antiresonance frequency of each resonator, and the equivalent parallel capacity of each resonator. FIG. 3 shows an equivalent circuit, wherein 201 represents parallel capacity, 202 represents serial capacity, 203 represents a serial inductor, and 204 represents resonance resistance. In this case, the equivalent parallel capacity refers to the parallel capacity 201 of FIG. 3. Here, the ratio of equivalent capacity between the resonator 101 in the serial arm and the resonator 102 in the parallel arm is approximately 1-to-1, so that the antiresonance frequency in the latticed arms (Here, a latticed arm is the same as a parallel arm) and the resonance frequency in the serial arms correspond approximately to each other in substance. Frequency characteristics of the resonators 101 and 102 are shown in FIG. 4. As shown in FIG. 4, the resonance frequency of the resonator 102 in the parallel arm is lower than the resonance frequency of the resonator 101 in the serial arm.

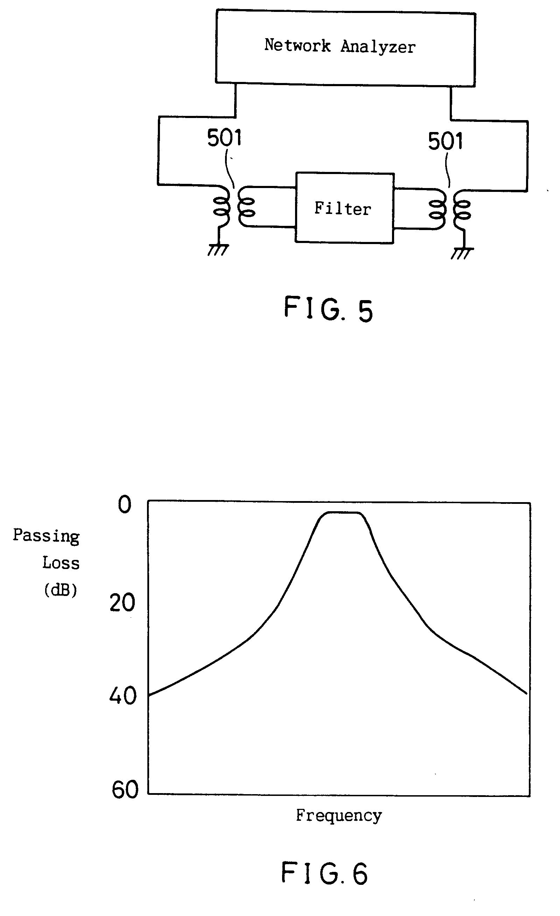

The above-mentioned balanced-type surface acoustic wave filter was converted to an unbalanced-type with the use of a circuit shown in FIG. 5, and the characteristics were measured. In FIG. 5, 501 represents a balun for balanced-unbalanced conversion. The reason for converting this balanced-type surface acoustic wave filter to an unbalanced-type is that the measuring equipment used here is for measurement of unbalanced circuits. The measurement results are shown in FIG. 6. As shown in FIG. 6, it was confirmed that a balanced-type surface acoustic wave filter constructed in accordance with the present invention has excellent frequency characteristics.

### Example 2

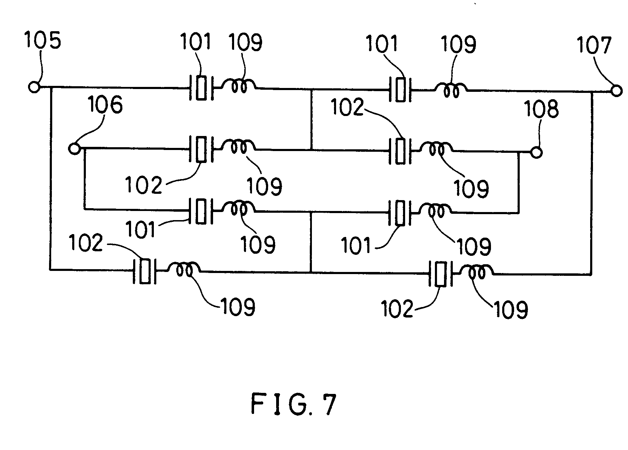

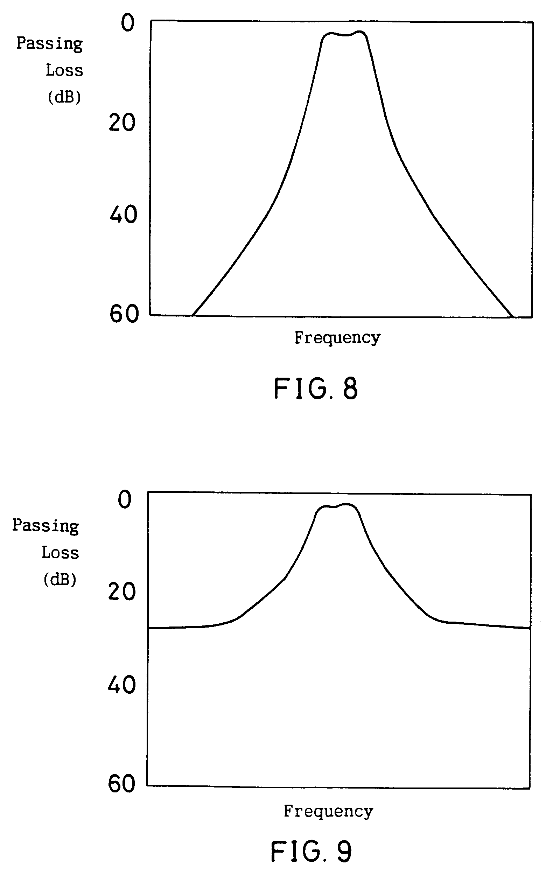

Next, a second embodiment of this invention will be explained. FIG. 7 is a schematic view of the second embodiment of a balanced-type surface acoustic wave filter of this invention. In this embodiment, the structure shown in the first embodiment was connected in a two-stage arrangement, which may be used when it is difficult to obtain sufficient out-of-band rejection with a one-stage arrangement. In this way, when the filter is connected in a two-stage arrangement, there is no part where wirings cross each other on the substrate surface, so that it is considered advantageous that wire bonding can be facilitated. Also in this case, as shown in FIG. 8, a balanced-type surface acoustic wave filter having sufficiently high out-of-band rejection could be attained, when compared with the first embodiment with one-stage (cf. FIG. 6).

### Example 3

Next, a third embodiment of this invention will be explained. In the first and second embodiments, wires for the connection of resonators or wirings were not particularly given special consideration. As a result, depending on the position or the design of the resonator, an inductor component was inserted serially in the resonator. Thus, since the amount of this inductor is different in each resonator, the resonance frequency could be changed, thereby deteriorating the filter characteristics in some cases. By referring to the equivalent circuit of the resonator shown in FIG. 3, it can be confirmed that the inductor 203 connected in series to the resonator changes the resonance frequency. Therefore, the wirings on the substrate surface were designed such that the inductor components connected serially to all the resonators became approximately the same, and a prototype was made. As a result, regardless of how the resonator was designed, the antiresonance frequency in latticed arms and the resonance frequency in serial arms corresponded approximately to each other, so that a balanced-type surface acoustic wave filter having excellent characteristics could be attained.

### Example 4

Next, a fourth embodiment of this invention will be explained. In the third embodiment, the wirings on the substrate surface were designed such that the inductor components connected serially to all the resonators became approximately the same. However, when the ratio of equivalent capacity between the resonator 101 in the serial arm and the resonator 102 in the parallel arm was changed, for example, from 1-to-1 to 1-to-2, deterioration of the filter characteristics was also observed, and was probably due to the change of resonance frequency. As expected, this was caused by the inductor components. In the third embodiment, it was appropriate that the inductors were the same, since the equivalent parallel capacity of the resonators was almost the same in both the serial arms and in the lattice arms. However, when the equivalent capacity is different, it is necessary to change the amount of inductors respectively in the serial arm and in the latticed arm.

By taking this aspect into consideration, the ratio of equivalent capacity between the resonator 101 in the serial arm and the resonator 102 in the parallel arm was changed to 2-to-1 (that is, the equivalent parallel capacity of the resonator having higher resonance frequency (resonator 101 in the serial arm) was determined to be greater than the equivalent parallel capacity of the resonator having lower resonance frequency (resonator 102 in the parallel arm) (cf. FIG. 4)). In addition, inductance at connection parts where each resonator in the latticed arms is connected, and the impedance at connection parts to be connected with the serial arms, were determined to be different, and in this way, a balanced-type surface acoustic wave filter was designed. The frequency characteristics are shown in FIG. 9. When compared with the first embodiment, it was confirmed that the out-of-band rejection deteriorated, but the pass band width broadened slightly. Accordingly, even if the ratio of equivalent capacity between the resonator 101 in the serial arm and resonator 102 in the parallel arm was changed from 1-to-1, by setting the inductance at connection parts where each resonator in the latticed arms is connected, and the impedance at connection parts to be connected with the serial arms, to be different, the antiresonance frequency in the latticed arms and the resonance frequency in the serial arms corresponded approximately to each other, so that a balanced-type surface acoustic wave filter having excellent characteristics could be attained.

### Example 5

Next, a fifth embodiment of this invention will be explained. In this embodiment, the connecting electrode used in the third embodiment was replaced with wires, and wirings on the substrate surface were designed such that inductors connected serially with all the resonators became approximately the same. As a result, the antiresonance frequency in the latticed arms and the resonance frequency in the serial arms corresponded approximately to each other. Thus, as in the third embodiment, when the results were compared with the case without consideration of the inductors, regardless of how the resonator was designed, a balanced-type surface acoustic wave filter having excellent characteristics could be attained.

### Example 6

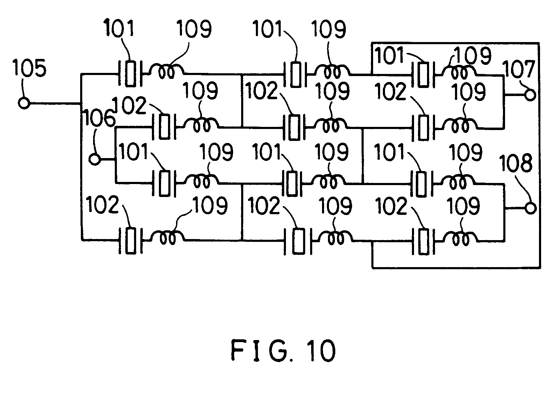

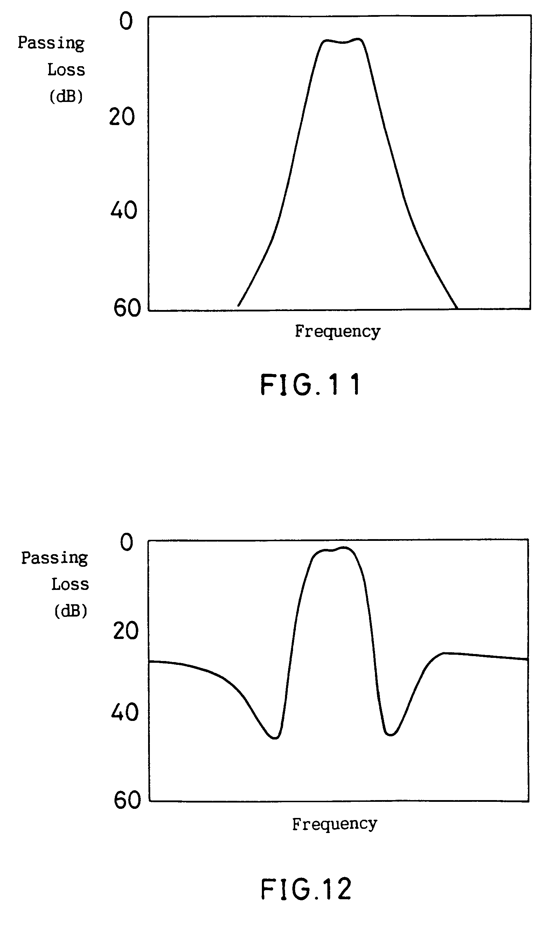

Next, a sixth embodiment of this invention will be explained. FIG. 10 is a schematic view showing the sixth embodiment of a balanced-type surface acoustic wave filter of this invention. In this embodiment, the structure shown in the first embodiment was connected in a three-stage arrangement, which may be used when it is difficult to obtain sufficient out-of-band rejection with either a one-stage or with a two-stage connection. In this way, when it is connected in a three-stage connection, there is no part where wirings cross each other on the substrate surface, so that it is considered advantageous that wire bonding can be facilitated, as this was also the case with the two-stage connection (cf. FIG. 7). Also in this case, as shown in FIG. 11, compared with the first embodiment using a one-stage connection (cf. FIG. 6), a balanced-type surface acoustic wave filter having sufficiently high out-of-band rejection could be attained. In addition, compared with the second embodiment with two-stage connection (cf. FIG. 8), the half-value width became slightly smaller.

Moreover, if the structure shown in the first embodiment were to be connected in a four-stage arrangement or higher, it is difficult to conduct wire bonding, since parts appear once again where wirings cross each other on the substrate surface. Furthermore, if the number of stages is increased too much, the size of the substrate will be larger, so the filter can not be miniaturized.

### Example 7

Next, a seventh embodiment of this invention will be explained. In this embodiment, the ratio of equivalent capacity in the resonators referred to in the fourth embodiment was changed. More specifically, the ratio of equivalent capacity between the resonator 101 in the serial arm and the resonator 102 in the parallel arm was determined to be 2-to-1. In other words, the equivalent parallel capacity of the resonator having higher resonance frequency (resonator 101 in serial arm) was determined to be greater than the equivalent parallel capacity of the resonator having lower resonance frequency (resonator 102 in the parallel arm) (cf. FIG. 4). This embodiment creates attenuation poles in the vicinity of pass frequencies of the filter, as shown in FIG. 12, and this is considered especially advantageous when high attenuation is required.

Furthermore, in the above-mentioned embodiments, the antiresonance frequency in the latticed arms and the resonance frequency in the serial arms correspond approximately to each other in substance, but excellent filter characteristics can be also attained when the resonance frequency in the latticed arms and the antiresonance frequency in the serial arms correspond approximately to each other.

In addition, although the above-mentioned embodiments made use of tantalic acid lithium for substrates, it is not necessarily limited to this material only. A substrate having substantially the same piezoelectric properties, for example, a quartz crystal substrate or a substrate of lithium niobate (LiNbO₃) may be used as well. In other words, by using a piezoelectric substance, a balanced-type surface acoustic wave filter having substantially the same excellent characteristics can be attained.

Moreover, although the above-mentioned embodiments made use of aluminium for electrodes, it is not necessarily limited to this material only. From the viewpoint of durability, by using aluminium mixed with copper or titanium, a balanced-type surface acoustic wave filter having substantially the same excellent characteristics can be attained.

## Claims

1. A balanced-type surface acoustic wave filter comprising:
four surface acoustic wave resonators (101,102) connected symmetrically and latticed to form at least one symmetrical and latticed circuit having latticed and serial arms,
wherein said at least one symmetrical and latticed circuit is arranged so that at least one of (i) an antiresonance frequency in the latticed arm and a resonance frequency in the serial arm, and (ii) a resonance frequency in the latticed arm and an antiresonance frequency in the serial arm, are substantially equal to each other,
characterized by
a connection part (103,104) for each of said four surface acoustic wave resonators, said four surface acoustic wave resonators being connected at each respective connection part,
wherein each of said connection parts (103,104) has a substantially same amount of inductance as means for adjusting the resonance frequencies in the latticed arm and in the serial arm.

2. A filter according to claim 1, further comprising:
a first connection part (103) for each surface acoustic wave resonator located in the latticed arm, said surface acoustic wave resonators in the latticed arm being connected at each respective first connection part,
a second connection part (104) for each surface acoustic wave resonator located in the serial arm, said surface acoustic wave resonators in the serial arm being connected at each respective second connection part,
wherein an inductance at said first connection parts differs from an impedance at said second connection parts.

3. A filter according to claim 1 or 2, wherein each of said connection parts comprises at least one of (i) a connecting electrode formed on the surface of a substrate comprising a surface acoustic wave resonator, and (ii) a wire connected to an external circuit.

4. A filter according to any one of claims 1 to 3, wherein said symmetrical and latticed circuit comprises a two-stage connection.

5. A filter according to any one of claims 1 to 4, wherein said symmetrical and latticed circuit comprises a three-stage connection.

6. A filter according to any one of claims 1 to 5, wherein two of said four surface acoustic wave resonators (101,102) are disposed in the serial arm, and two of said four surface acoustic wave resonators are disposed in the latticed arm.

## Patentansprüche

1. Symmetrisches akustisches Oberflächenwellenfilter mit:
vier akustischen Oberflächenwellenresonatoren (101,102), die symmetrisch verbunden und gekreuzt sind, um mindestens eine symmetrische und gekreuzte Schaltung zu bilden, die gekreuzte und serielle Zweige aufweist,
wobei die mindestens eine symmetrische und gekreuzte Schaltung so angeordnet ist, daß mindestens eine (i) einer Antiresonanzfrequenz im gekreuzten Zweig und einer Resonanzfrequenz im seriellen Zweig, und (ii) einer Resonanzfrequenz im gekreuzten Zweig und einer Antiresonanzfrequenz im seriellen Zweig im wesentlichen einander gleich sind,
gekennzeichnet durch
ein Verbindungsteil (103,104) für jeden der vier akustischen Oberflächenwellenresonatoren, wobei die vier akustischen Oberflächenwellenresonatoren an jedem jeweiligen Verbindungsteil angeschlossen sind,
wobei jedes der verbindungsteile (103,104) einen im wesentlichen gleichen Betrag der Induktivität aufweist, als eine Einrichtung zum Einstellen der Resonanzfrequenzen im gekreuzten Zweig und im seriellen Zweig.

2. Filter nach Anspruch 1, das ferner aufweist:
ein erstes verbindungsteil (103) für jeden akustischen Oberflächenwellenresonator, der im gekreuzten Zweig angeordnet ist, wobei die akustischen Oberflächenwellenresonatoren im gekreuzten Zweig an jedes jeweilige erste Verbindungsteil angeschlossen sind,
ein zweites Verbindungsteil (104) für jeden akustischen Oberflächenwellenresonator, der im seriellen Zweig angeordnet ist, wobei die akustischen Oberflächenwellenresonatoren im seriellen Zweig an jedes jeweilige zweite Verbindungsteil angeschlossen sind,
wobei eine Induktivität an den ersten Verbindungsteilen sich von einer Impedanz an den zweiten Verbindungsteilen unterscheidet.

3. Filter nach Anspruch 1 oder 2, wobei jedes der Verbindungsteile mindestens (i) eine Verbindungselektrode, die auf der Oberfläche eines Substrats ausgebildet ist, das einen akustischen Oberflächenwellenresonator aufweist, und/oder (ii) einen Draht, der mit einer äußeren Schaltung verbunden ist, aufweist.

4. Filter nach einem der Ansprüche 1 bis 3, wobei die symmetrische und gekreuzte Schaltung eine zweistufige Verbindung aufweist.

5. Filter nach einem der Ansprüche 1 bis 4, wobei die symmetrische und gekreuzte Schaltung eine dreistufige Verbindung aufweist.

6. Filter nach einem der Ansprüche 1 bis 5, wobei zwei der vier akustischen Oberflächenwellenresonatoren (101,102) im seriellen Zweig angeordnet sind und zwei der vier akustischen Oberflächenwellenresonatoren im gekreuzten Zweig angeordnet sind.

## Revendications

1. Filtre d'onde acoustique de surface de type équilibré comprenant :
quatre résonateurs d'onde acoustique de surface (101, 102) connectés de manière symétrique et treillissés de façon à former au moins un circuit symétrique et treillissé comportant des bras treillissés et en série,
dans lequel ledit au moins un circuit symétrique et treillissé est disposé de sorte qu'au moins une parmi (i) une fréquence d'antirésonance dans le bras treillissé et une fréquence de résonance dans le bras en série, et (ii) une fréquence de résonance dans le bras treillissé et une fréquence d'antirésonance dans le bras en série, sont réellement égales l'une par rapport à l'autre,
caractérisé par
une partie de connexion (103, 104) pour chacun desdits quatre résonateurs d'onde acoustique de surface, lesdits quatre résonateurs d'onde acoustique de surface étant connectés à chacune des parties de connexion respectives,
dans lequel chacune desdites parties de connexion (103, 104) présente réellement une même quantité d'inductance comme moyen d'ajustement des fréquences de résonance dans le bras treillissé et dans le bras en série.

2. Filtre selon la revendication 1, comprenant de plus :
une première partie de connexion (103) pour chaque résonateur d'onde acoustique de surface situé dans le bras treillissé, lesdits résonateurs d'onde acoustique de surface dans le bras treillissé étant connectés à chaque première partie de connexion respective,
une seconde partie de connexion (104) pour chaque résonateur d'onde acoustique de surface situé dans le bras en série, lesdits résonateurs d'onde acoustique de surface dans le bras en série étant connectés à chaque seconde partie de connexion respective,
dans lequel une inductance au niveau desdites premières parties de connexion diffère d'une impédance au niveau desdites secondes parties de connexion.

3. Filtre selon la revendication 1 ou 2, dans lequel chacune desdites parties de connexion comprend au moins un parmi (i) une électrode de connexion formée sur la surface d'un substrat comprenant un résonateur d'onde acoustique de surface, et (ii) un fil électrique connecté à un circuit externe.

4. Filtre selon l'une quelconque des revendications 1 à 3, dans lequel ledit circuit symétrique et treillissé comprend une connexion à deux étages.

5. Filtre selon l'une quelconque des revendications 1 à 4, dans lequel ledit circuit symétrique et treillissé comprend une connexion à trois étages.

6. Filtre selon l'une quelconque des revendications 1 à 5, dans lequel deux desdits quatre résonateurs d'onde acoustique de surface (101, 102) sont disposés dans le bras en série, et deux desdits quatre résonateurs d'onde acoustique de surface sont disposés dans le bras treillissé.
